# EUROPEAN PATENT APPLICATION

(11) **EP 4 294 143 A1**
(43) Date of publication of application: **20.12.2023**
(21) Application number: 22178856.5
(22) Date of filing: 14.06.2022
(51) Int. Cl.: H05K 13/04

(54) **FEEDING ARRANGEMENT FOR AN AUTOMATED PLACEMENT MACHINE FOR THE MANUFACTURING OF ELECTRONIC DEVICES**

(71) Applicant: BIOTRONIK SE & Co. KG, 12359 Berlin (DE)
(72) Inventor: Koch, Sascha, Sherwood, 97140 (US); Albers, Delancy Rose, Milwaukie, 97267 (US)
(74) Representative: Biotronik Corporate Services SE

(57) **Abstract**

A feeding arrangement (2) for an automated placement machine (1) for the manufacturing of electronic devices (3) comprises a feeder device (20A, 20B) for feeding components (220) towards a pickup location (P), the feeder device (20A, 20B) comprising a body (200) and an advancing unit (201). Aa cartridge (21) is received in the body (200) of the feeder device (20A, 20B). A stack of sheets (22) is received in the cartridge (21) and carries said components (220). The advancing unit (201) of the feeder device (20A, 20B) is configured to interact with a sheet of the stack of sheets (22) of the cartridge (21) for advancing said sheet along a feeding direction (F) for feeding the components (220) towards the pickup location (P).

## Description

The instant invention relates to a feeding arrangement for an automated placement machine for the manufacturing of electronic devices, and to a method for feeding components to an automated placement machine for the manufacturing of electronic devices.

For the manufacturing of electronic devices, in particular on printed circuit boards, automated placement machines are used, which place electric and electronic components on a carrier such as a printed circuit board in an automated fashion for a subsequent processing, in particular for a soldering to attach the components to the carrier. Such components may in particular be so called Surface Mount Devices (SMD) which are attached to a printed circuit board using a reflow soldering technique allowing for the simultaneous joining of a large number of components to a printed circuit board.

Within automated placement machines, typically components are processed at high speed to place a large number of components on associated carriers in a short amount of time. Automated placement machines therefore are equipped to load and store a variety of component types at large quantities to maximize an unattended runtime. For this, a feeding arrangement is used, which provides for a reservoir of components which may be fed in an automated fashion to the automated placement machine for processing within the automated placement machine.

In a feeding arrangement of this kind there is a desire for a high volumetric efficiency to limit a required storage space, for an easy handling and for a use of inexpensive materials and equipment for a packaging of the components.

In known approaches, for example a so-called Tape in Reel feeding of components is employed. For example, US 2003/0000959 A1 discloses a storage system including a storage platform cantilever above a surface mount placement machine. A component feeder cartridge contains a component reel comprising a wound tape on which components are stored. By unwinding the tape components may be picked from the tape using a vacuum head in order to place components using an automated placement machine.

Other Tape in Reel placement machines are for example disclosed in US 2019/0223334 A1 and JP 2017-45805 A.

In other approaches bulk feeders or matrix trays are used to feed components.

For example, EP 0 986 942 B1 discloses a feeding method in which bar magazines are used to store components, a lifting device being used to lift components out of a corresponding bar magazine.

CN 208326664 U discloses a use of matrix trays for feeding components to an automated placement machine.

It is an object of the instant invention to provide a feeding arrangement and a method for feeding components which allow for a high volumetric efficiency and an easy handling to feed electric or electronic components to an automated placement machine.

In one aspect, a feeding arrangement for an automated placement machine for the manufacturing of electronic devices comprises: a feeder device for feeding components towards a pickup location, the feeder device comprising a body and an advancing unit; a cartridge to be received in the body of the feeder device; and a stack of sheets received in the cartridge and carrying said components; wherein the advancing unit of the feeder device is configured to interact with a sheet of the stack of sheets of the cartridges for advancing said sheet along a feeding direction for feeding the components towards the pickup location.

Accordingly, the feeding arrangement uses a feeder device which is configured to hold a cartridge containing a stack of sheets carrying the components to be fed to the automated placement machine. The feeder device comprises a body and an advancing unit, the body serving to receive and hold the cartridge, whereas the advancing unit is configured to interact with one sheet of the stack of sheets contained in the cartridge at a time in order to advance the particular sheet along a feeding direction for feeding components arranged on the sheet towards a pickup location. At the pickup location a component is picked up and placed, using a pickup device, e.g. on a carrier such as a printed circuit board for fabricating an electronic device.

Components hence are arranged on sheets which are contained in the cartridge. As the sheets are provided as a stack of sheets, each sheet carrying a multiplicity of components, the components may be received and stored within the cartridge with a high volumetric efficiency. By advancing one sheet at a time from the cartridge such that with each advancing step one component of the currently advanced sheet is transported towards the pickup location, components one at a time are fed towards an automated placement machine and may be picked up at the pickup location by means of a pickup device, for example employing a vacuum head configured to pick a component employing a negative pressure.

If all sheets of the cartridge have been used, the cartridge may be released from the feeding device in order to place a new cartridge in the feeding device, such that the feeding operations may be continued.

In one embodiment, the feeding arrangement comprises multiple feeder devices aligned along an alignment direction. Each device herein comprises a body for receiving an associated cartridge and an advancing unit configured to interact with a sheet of a stack of sheets received in the associated cartridge for advancing said sheet along the feeding direction. By means of the multiple feeder devices different components stored in the different cartridges received within the different feeder devices may be fed to the automated placement machine. The feeder devices are aligned with respect to one another, the alignment direction in particular being directed perpendicular to the feeding direction and a height direction along which the sheets of the stack of sheets of the cartridges are stacked.

The cartridges of the different feeder devices may contain alike components or may contain different components. In particular, by means of the different feeder devices a variety of different components may be fed to an automated placement machine.

In one embodiment, each sheet of the stack of sheets of a particular cartridge extends longitudinally along the feeding direction. The sheets herein are stacked in that they are placed one on top of the other along the height direction.

In one embodiment, each sheet of the stack of sheets comprises a sheet body formed from a rigid material. This is to be understood in that the sheet body comprises a low compliance and conforms to its longitudinal, straight shape within the cartridge received in the feeder device. The sheet body may for example be made from a hard paper material or from a plastics material.

In one embodiment, each sheet of the stack of sheets comprises an arrangement of pockets in which the components to be fed to the automated placement machine are received. The pockets for example may be formed as recesses formed in the sheet body in each of which one component is received. The pockets of a single sheet herein may be aligned along the feeding direction at regular distances, such that an advancing of the sheet along the feeding direction by a predefined, constant step width causes a stepwise movement of components of the sheet towards the pickup location, one component after the other reaching the pickup location for a pickup operation by means of a pickup device of the automated placement machine.

In one embodiment, the sheets form a vertical stack in that they are stacked along a height direction perpendicular to the feeding direction. The height direction in particular may be perpendicular to the feeding direction as well as to the alignment direction. The stack of sheets has a longitudinal extension along the feeding direction corresponding to the length of the sheets but may comprise a rather small width along the alignment direction, which allows to use multiple feeder devices aligned along the alignment direction to feed different components to the automated placement machine from different cartridges containing different stack of sheets.

In one embodiment, the advancing unit is configured to advance an upper sheet of the stack of sheets facing the advancing unit along the feeding direction. The advancing unit in particular is configured to interact with the upper sheet of the stack of sheets, the upper sheet facing the advancing unit. The advancing unit, for this, may for example comprise a drive element such as a drive wheel to act onto the upper sheet, such that the upper sheet may be moved along the feeding direction in a stepwise movement for forwarding one component after another towards the pickup location.

By moving a particular sheet in the feeding direction, the sheet is continuously moved out of the cartridge and, after it is removed from the cartridge by means of the advancing unit, is discarded, for example by dropping the sheet. Once the sheet is removed from the cartridge, the advancing unit is configured to interact with a next upper sheet of the stack of sheets in order to advance that sheet, which now forms the upper sheet of the stack of sheets facing the advancing unit, along the feeding direction for feeding components of the sheet towards the pickup location.

By continuing this process one sheet after the other is advanced, and components of the particular sheet are moved towards the pickup location. Once all sheets of the cartridge have been used, the cartridge may be removed from the feeder device, and a new cartridge may be placed in the feeder device for continuing the process.

In one embodiment, the body of the feeding device comprises side walls between which the cartridge is received. The feeder device may comprise a generally slender shape, with the sidewalls being arranged in parallel with respect to one another and forming a receptacle therebetween for receiving the cartridge. A width of the feeder device along the alignment direction, corresponding to a distance between the side walls, herein is small in comparison to an extension of the feeder device in a plane perpendicular to the alignment direction, allowing to align multiple feeder devices along the alignment direction with a high volumetric efficiency and hence with a high storage capacity for components to be fed to the automated placement machine.

In one embodiment, the cartridge comprises side faces, the stack of sheets being received in between the side faces. The cartridge in particular may provide for a housing for the stack of sheets, the housing for example being formed for example by the side faces and a top and a bottom face connecting the side faces, such that the stack of sheets is encompassed by the housing but may be moved with respect to the housing along the feeding direction, in particular to remove the sheets from the cartridge by the advancing unit.

In one embodiment, the feeding arrangement comprises a reader device. The cartridge herein may comprise a marking tag encoding information associated with the cartridge, for example identifying components placed on the sheets received in the cartridge. The marking tag is readable by the reader device. The marking tag for example may be arranged on a top face of the cartridge, such that the marking tag is accessible and readable by the reader device in an arrangement in which multiple feeder devices are aligned along an alignment direction. The marking tag in particular may be a barcode, a QR code, an RFID tag or another marking label encoding information.

In one embodiment, the cartridge is releasable from the feeder device along an unloading direction which is collinear with the feeding direction. The unloading direction for example may be directed opposite to the feeding direction. This allows for a one-axis handling of the feeder device, allowing to insert a cartridge into the feeder device for processing components contained in the cartridge, and to withdraw the cartridge from the feeder device after the components contained in the cartridge have been fed to the automated placement machine.

By means of a feeding arrangement as proposed herein, in particular an automated, simplified transfer of components into feeder devices may be achieved. In particular, in comparison to some tape in reel solutions a simplification may be achieved in that it is not necessary to thread material through feeder mechanisms. To load a feeder device, it simply is required to place the cartridge in the corresponding feeder device, wherein no additional handling steps may be necessary to allow a feeding of components from the cartridge.

As each cartridge may be identified by an associated marking tag, an automated handling may further include an automatic identification of a cartridge towards a system, hence reducing inspection and configuration needs when loading a feeder device.

In another aspect, a method for feeding components to an automated placement machine for the manufacturing of electronic devices comprises: feeding components towards a pickup location using a feeder device, the feeder device comprising a body and an advancing unit; and interacting, using the advancing unit of the feeder device, with a sheet of a stack of sheets of a cartridge for advancing said sheet along a feeding direction for feeding components towards the pickup location, the cartridge being received in the body of the feeder device and the stack of sheets being received in the cartridge and carrying said components.

The advantages and advantageous embodiments as described above for the feeding arrangement equally apply also to the method, such that it shall be referred to the above in this respect.

In particular, within the method the advancing unit may advance an upper sheet of the stack of sheets facing the advancing unit along the feeding direction until the upper sheet is removed from the stack of sheets, and subsequently advances a next upper sheet of the stack of sheets to process one sheet after the other. The sheets in particular may be advanced in a stepwise operation, a step width corresponding to a distance between pockets in which components are received on the sheets, such that one component after the other is forwarded to the pickup location to be picked up by a pickup device of the automated placement machine.

The various features and advantages of the present invention may be more readily understood with reference to the following detailed description and the exemplary embodiments shown in the drawings. Herein,
- Fig. 1: shows a schematic drawing of an automated placement machine employing a feeding arrangement for feeding components towards a pickup device for placing the components on an electronic device;
- Fig. 2: shows a perspective view of an embodiment of a feeding arrangement comprising a multiplicity of feeder devices;
- Fig. 3: shows a view of the arrangement of Fig. 2, with a cartridge being partially removed from one of the feeder devices;
- Fig. 4: shows an embodiment of a cartridge to be received in a feeder device;
- Fig. 5: shows a stack of sheets contained in a cartridge;
- Fig. 6: shows a single sheet carrying a multiplicity of components;
- Fig. 7: shows a single feeder device with a cartridge received therein;
- Fig. 8: shows a view of the feeder device during the advancing of a sheet of a stack of sheets of a cartridge; and
- Fig. 9: shows a schematic view of a functional setup of a feeder device.

In the following, embodiments of the invention shall be described in detail with reference to the drawings. In the drawings, like reference numerals designate like structural elements.

It is to be noted that the embodiments are not limiting for the invention, but merely represent illustrative examples.

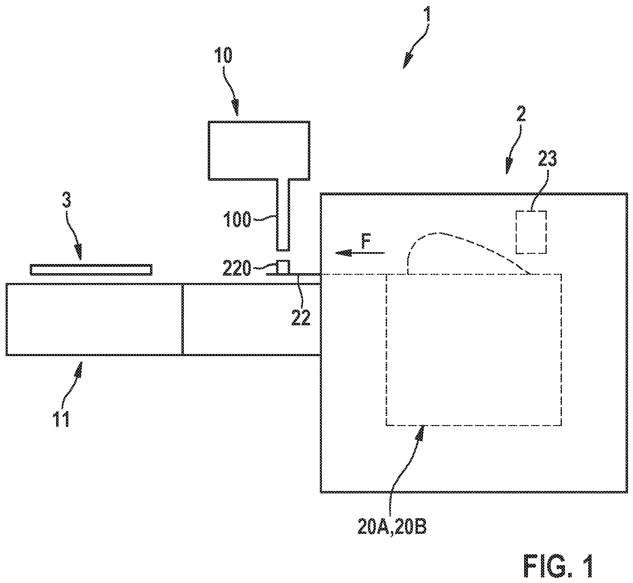

Referring now to Fig. 1, an automated placement machine 1 may generally comprise, as schematically indicated in Fig. 1, a pickup device 10 and a conveyor arrangement 11 on which a carrier, such as a printed circuit board, is conveyed for producing an electronic device 3. By means of the pickup device 10 components 220 are picked up using a picking head 100 and are placed on the carrier, wherein after placing a desired configuration of components on the carrier the assembly may be processed in order to join the components to the carrier to form the electronic device 3.

Components 220 of this kind may in particular be SMD components. For joining the components 220 to the carrier, in particular a printed circuit board, a soldering technique such as a reflow soldering process may be employed.

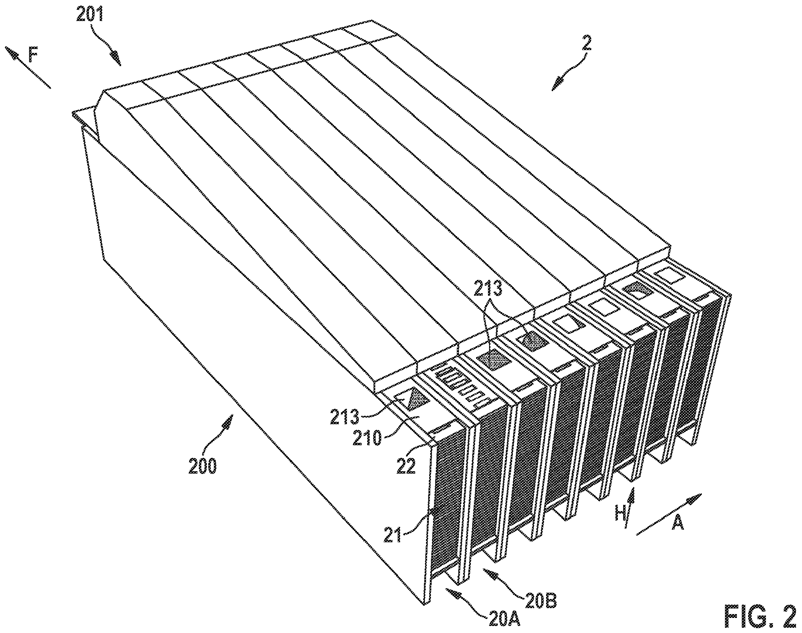

The components 220 are fed to the automated placement machine 1 by means of a feeding arrangement 2 comprising a multiplicity of feeder devices 20A, 20B, as they are shown in one embodiment in Fig. 2. Each feeder device 20A, 20B is equipped with a cartridge 21 containing a stack of sheets 22, the sheets 22 carrying components 220 to be fed to the automated placement machine 1.

The feeder devices 20A, 20B herein may carry cartridges 21 containing different electric or electronic components 220, e.g. SMD components. It however is also conceivable that at least some of the feeder devices 20A, 20B contain alike components 220.

As visible from Fig. 2, each feeder device 20A, 20B has a slender shape, the feeder devices 20A, 20B being aligned along an alignment direction A. Each feeder device 20A, 20B comprises a body 200 in which a corresponding cartridge 21 is received, and an advancing unit 201 which serves to advance a sheet 22 from the cartridge 21 for feeding components 220 along a feeding direction F towards the automated placement machine 1.

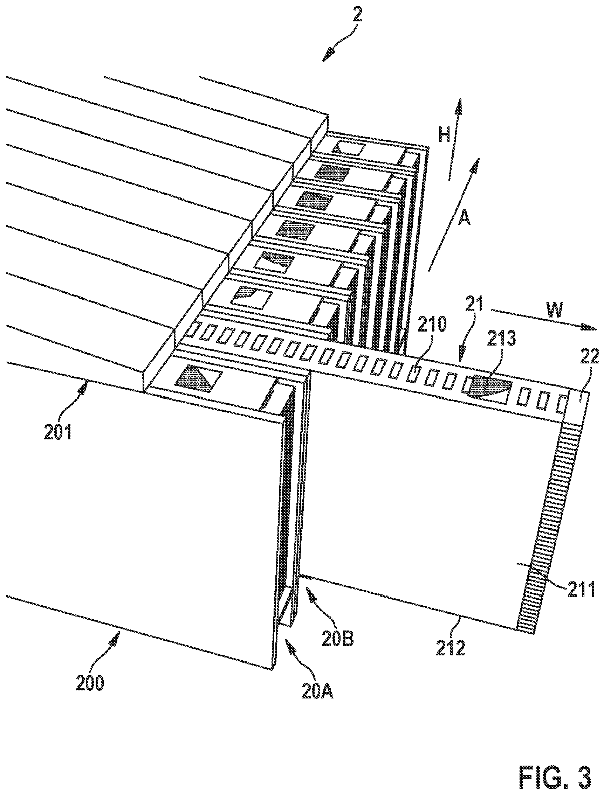

Referring now to Fig. 3, the cartridges 21 may be loaded into the feeder devices 20A, 20B along the feeding direction F, and may be removed from the feeder devices 20A, 20B, for example after using all sheets 22 contained in the cartridges 21, along an unloading direction W opposite to the feeding direction F. The cartridges 21 hence may be inserted into the feeder devices 20A, 20B and may be removed from the feeder devices 20A, 20B along a single axis, allowing for an easy handling for loading and unloading the feeder devices 20A, 20B.

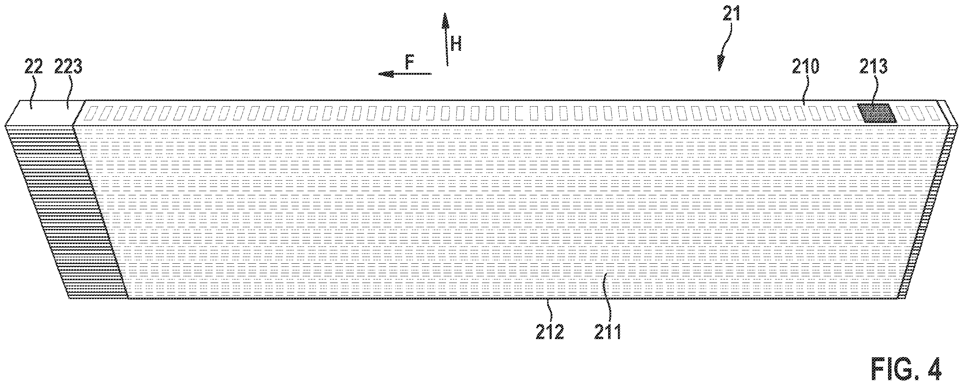

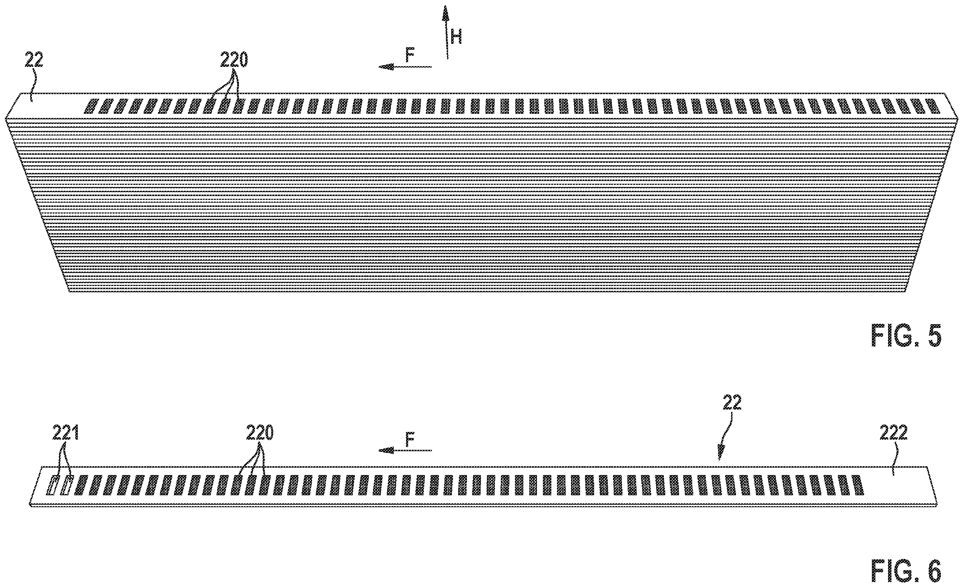

Referring now to Figs. 4 to 6, each cartridge 21 (in an initial, loaded state) is loaded with a stack of sheets 22, each sheet 22 having a longitudinal, straight shape extending longitudinally along the feeding direction F. By stacking multiple sheets 22 on top of each other a stack of sheets 22 is formed along a height direction H, the stack of sheets being received within the cartridge 21 for placement into one of the feeder devices 20A, 20B.

Each sheet 22 for example is made from a rigid, low-compliable material, for example made from a hard paper material or a plastics material. Each sheet 22 comprises a sheet body 222 forming a multiplicity of pockets 221 for receiving the components 220, the pockets 221 being formed such that the components 220 e.g. do not protrude beyond a surface of the sheet body 222 when they are received in the pockets 221, but are flush with the surface of the sheet body 222. The pockets 221 are aligned with respect to one another along the feeding direction F and are spaced with respect to each other at regular distances, such that a regular arrangement of pockets 221 on the sheet body 222 is formed.

The cartridge 21, as shown in Fig. 4, forms a housing for receiving the stack of sheets 22. The cartridge 21 in particular comprises side faces 211, a top face 210 and in addition a bottom face 212 forming a receptacle in which the stack of sheets 22 is received. The sheets 22 herein are removable from the cartridge 21 along the feeding direction F by means of the advancing unit 201 of the feeder device 20A, 20B.

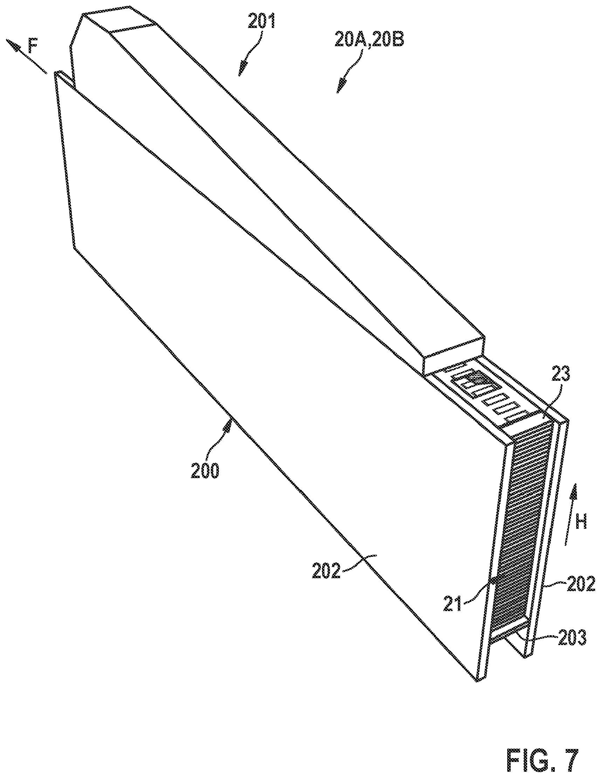

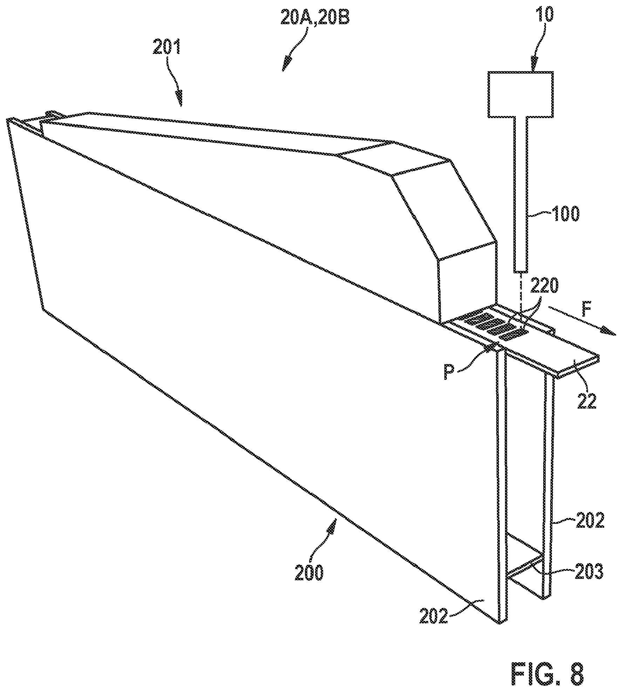

The advancing unit 201 of each feeder device 20A, 20B is configured to advance an upper sheet 22 of the stack of sheets 22 facing the advancing unit 201 in the feeding direction F, as this is shown in Figs. 7 and 8. By means of the advancing unit 201 the sheet 22 in particular is advanced in a stepwise movement, such that one component 220 after another is placed at a pickup location P at which the component 220 may be picked up by a pickup device 10 of the automated placement machine 1, as this is indicated in Fig. 8.

The advancing unit 201 is configured to interact with the uppermost sheet 22 of the stack of sheets 22 received in the particular feeder device 20A, 20B. By advancing the uppermost sheet 22, the sheet 22 is continuously moved in a stepwise fashion in the feeding direction F and ultimately removed from the cartridge 21, upon which the sheet 22 is discarded by letting it drop once it is moved out of the range of the cartridge 21 and the advancing unit 201. Subsequently, the advancing unit 201 interacts with the now uppermost sheet 22, such that the process continues and the next sheet 22 is advanced in the feeding direction F.

Once all sheets 22 of the cartridge 21 have been used, the cartridge 21 may be removed and replaced by another cartridge 21 for continuing the operation.

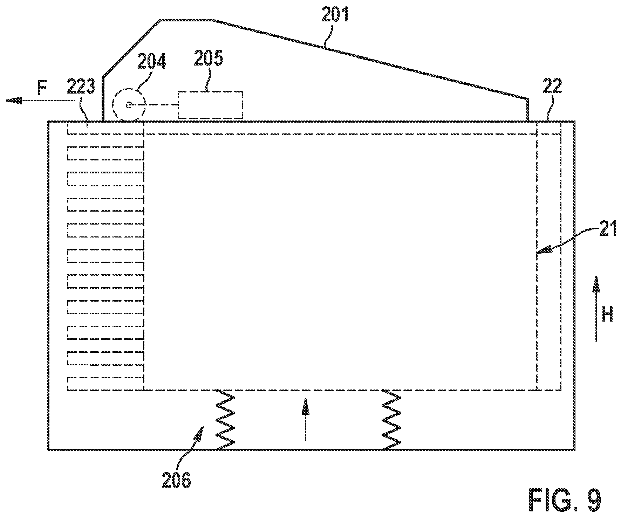

As it is schematically indicated in Fig. 9, the feeder device 20A, 20B may comprise a tensioning device 206 serving to provide a tensioning force on the stack of sheets 22, such that the stack of sheets 22 is biased towards the advancing unit 201 for interacting with the advancing unit 201. The tensioning device 206 may for example use one or multiple elastic springs and may act onto a bottom sheet 22 of the stack of sheets 22, for example through openings in a bottom face 212 of the cartridge 21.

The advancing unit 201 for example comprises a drive element 204 in the shape of a drive wheel for acting onto the uppermost sheet 22, for example a front portion 223 of the upper sheet 22 to advance that sheet 22 in the feeding direction F. An electric drive motor 205 is used to drive the drive wheel 204 in a stepwise fashion for moving the sheet 22 one step after the other for advancing one component after the other towards the pickup location P.

Referring now again to Fig. 2, on the top face 210 of each cartridge 21 a marking tag 213 is placed, for example in the shape of a barcode, a QR code or an RFID tag. The marking tag 213 serves to identify the particular cartridge 21, for example by containing readable information identifying the components included in the particular cartridge 21. The marking tag 213 is placed in a rear portion of the cartridge 21 outside of the advancing unit 21 when the cartridge 21 is placed within the feeder device 20A, 20B, such that the marking tags 213 of the cartridges 21 are accessible and readable when the cartridges 21 are placed in the feeder devices 20A, 20B.

As visible from Fig. 1, the feeding arrangement 2, in one embodiment, comprises a reader device 23 which is configured to read the marking tags 213 of the cartridges 21 loaded into the feeder devices 20A, 20B. This may facilitate an automated operation of the feeding arrangement 2, in that the cartridges 21 may be automatically identified and inspected when the cartridges 21 are placed in the feeder devices 20A, 20B. Hence, the system may automatically identify which components are present in which feeder device 20A, 20B, such that operation of the feeding arrangement 2 may be adapted correspondingly.

### List of reference numerals

- 1: Automated placement machine
- 10: Pick-up device
- 100: Picking head
- 11: Conveyor arrangement
- 2: Feeding arrangement
- 20A, 20B: Feeder device
- 200: Body
- 201: Advancing unit
- 202: Side walls
- 203: Bottom wall
- 204: Drive element
- 205: Drive motor
- 206: Tensioning device
- 21: Cartridge
- 210: Top face
- 211: Side faces
- 212: Bottom face
- 213: Marking tag
- 22: Sheet
- 220: Component
- 221: Pocket
- 222: Sheet body
- 223: Front portion
- 23: Reader device
- 3: Electronic device
- A: Alignment direction
- F: Feeding direction
- H: Height direction
- P: Pickup location
- W: Unloading direction

## Claims

1. A feeding arrangement (2) for an automated placement machine (1) for the manufacturing of electronic devices (3), comprising:
a feeder device (20A, 20B) for feeding components (220) towards a pickup location (P), the feeder device (20A, 20B) comprising a body (200) and an advancing unit (201);
a cartridge (21) to be received in the body (200) of the feeder device (20A, 20B); and
a stack of sheets (22) received in the cartridge (21) and carrying said components (220);
wherein the advancing unit (201) of the feeder device (20A, 20B) is configured to interact with a sheet of the stack of sheets (22) of the cartridge (21) for advancing said sheet along a feeding direction (F) for feeding the components (220) towards the pickup location (P).

2. The feeding arrangement (2) according to claim 1, comprising multiple feeder device (20A, 20B) aligned along an alignment direction (A), each feeder device (20A, 20B) comprising a body (200) for receiving an associated cartridge (21) and an advancing unit (201) configured to interact with a sheet of a stack of sheets (22) received in the associated cartridge (21) for advancing said sheet along the feeding direction (F).

3. The feeding arrangement (2) according to claim 1 or 2, wherein each sheet of the stack of sheets (22) extends longitudinally along the feeding direction (F).

4. The feeding arrangement (2) according to one of claims 1 to 3, wherein each sheet of the stack of sheets (22) comprises a sheet body (222) formed from a rigid material.

5. The feeding arrangement (2) according to one of the preceding claims, wherein each sheet of the stack of sheets (22) comprises an arrangement of pockets (221) in which said components (220) are received.

6. The feeding arrangement (2) according to claim 5, wherein said pockets (221) are aligned along the feeding direction (F).

7. The feeding arrangement (2) according to one of the preceding claims, wherein the sheets of the stack of sheets (22) are stacked along a height direction (H) perpendicular to the feeding direction (F).

8. The feeding arrangement (2) according to one of the preceding claims, wherein the advancing unit (201) is configured to advance an upper sheet of the stack of sheets (22) facing the advancing unit (201) along the feeding direction (F).

9. The feeding arrangement (2) according to claim 8, wherein the advancing unit (201) is configured to advance said upper sheet of the stack of sheets (22) along the feeding direction (F) until the upper sheet is removed from the stack of sheets (22), and to subsequently advance a next upper sheet of the stack of sheets (22) along the feeding direction (F).

10. The feeding arrangement (2) according to one of the preceding claims, wherein the body (200) of the feeder device (20A, 20B) comprises side walls (202) between which the cartridge (21) is received.

11. The feeding arrangement (2) according to one of the preceding claims, wherein the cartridge (21) comprises side faces (211), the stack of sheets (22) being received in between the side faces (211).

12. The feeding arrangement (2) according to one of the preceding claims, wherein the feeding arrangement (2) comprises a reader device (23) and the cartridge (21) comprises a marking tag (213) encoding information associated with the cartridge (21), the marking tag (213) being readable by the reader device (23).

13. The feeding arrangement (2) according to one of the preceding claims, wherein the cartridge (21) is releasable from the feeder device (20A, 20B) along an unloading direction (W) which is collinear with the feeding direction (F).

14. A method for feeding components to an automated placement machine (1) for the manufacturing of electronic devices (3), comprising:
feeding components (220) towards a pickup location (P) using a feeder device (20A, 20B), the feeder device (20A, 20B) comprising a body (200) and an advancing unit (201); and
interacting, using the advancing unit (201) of the feeder device (20A, 20B), with a sheet of a stack of sheets (22) of a cartridge (21) for advancing said sheet along a feeding direction (F) for feeding components (220) towards the pickup location (P), the cartridge (21) being received in the body (200) of the feeder device (20A, 20B) and the stack of sheets (22) being received in the cartridge (21) and carrying said components (220).

15. The method according to claim 14, wherein the advancing unit (201) advances an upper sheet of the stack of sheets (22) facing the advancing unit (201) along the feeding direction (F) until the upper sheet is removed from the stack of sheets (22), and subsequently advances a next upper sheet of the stack of sheets (22).
